# EUROPEAN PATENT SPECIFICATION

(11) **EP 3 309 806 B1**
(45) Date of publication and mention of the grant of the patent: **05.08.2020**
(21) Application number: 16194028.3
(22) Date of filing: 14.10.2016
(51) Int. Cl.: H01H 9/54, H01H 50/04, H01R 13/66, B60R 16/03, H01H 71/12

(54) **INTELLIGENT SWITCH FOR AUTOMOTIVE APPLICATION**
INTELLIGENTER SCHALTER ZUR AUTOMOBILANWENDUNG
COMMUTATEUR INTELLIGENT POUR APPLICATION AUTOMOBILE

(43) Date of publication of application: 18.04.2018
(73) Proprietor: TE Connectivity Germany GmbH, 64625 Bensheim (DE); TE Connectivity Corporation, Berwyn, PA 19312 (US)
(72) Inventor: Einhorn, Joerg, 13591 Berlin (DE); Kakerow, Ralf, 64289 Darmstadt (DE); Lawrence, Aruna, 64625 Bensheim (DE); Michael, Mathias, 68789 St. Leon-Rot (DE); Ngongang, Georges, 57050 Longeville les Metz (FR); Ostermann, Ruediger, 64468 Rimbach (DE); Rohr, Steve, Birmingham, MI 48009 (US); Shocket, Abraham, Cary, NC 27511 (US)
(74) Representative: Grünecker Patent- und Rechtsanwälte PartG mbB

(56) References cited:
- WO-A1-2016/135126
- DE-A1- 3 345 701
- DE-A1-102015 000 576
- US-A1- 2012 293 891
- US-A1- 2016 203 932

## Description

The invention relates to an electric switch for automotive application, in particular to a resettable and/or programmable fuse, comprising at least one inlet, at least one outlet and a switch circuit electrically connecting the at least one inlet and the at least one outlet wherein the switch circuit comprises at least two switching submodules selected from the list of an electromechanic switching submodule and an electric switching submodule, wherein the switch circuit comprises at least one electromechanic switching submodule and at least one electric switching submodule, and wherein the switch further comprises a control unit for controlling an operating state of the at least two switching submodules.

The electrical/electronic (E/E) systems are found everywhere within different subsystems in a vehicle: engine and powertrain, chassis, body and comfort, infotainment, navigation, driver assistance, and interactive systems. This is accompanied by the wiring harness to support them in terms of cabling and network interfacing. The wiring harness alone is the third highest cost component (behind the engine and chassis) and also the third heaviest component (behind the chassis and engine) in a car. Thus, any solution that reduces this weight directly contributes to save cost and environment.

The continuous growth in the number of E/E features and advancements push the demand for a comprehensive and dynamic architecture that encompasses this complexity via a common interconnecting infrastructure. Such an infrastructure includes communication as well as power distribution, physical placement of components, and the mapping of functionality on the components. This requires different communication schemes and gateways to enable cross-networking between smart nodes. The general benefits of using a common E/E architecture are the possibility of reusing data (i.e. from sensors) for different applications, the optimization of the wiring harness, simple extensibility when adding new functions, and the support for having different expansion modules/stages.

Electric automotive switches are known from the art and are available with standardized sizes and/or connection means, i.e. contact terminal for placing the switch in a circuit, such as a load circuit of an automobile. An electric fuse is a specific switch interrupting the load circuit in case of a specific condition, e.g. overload, mismatch load, overvoltage, or failure of the device connected to the load circuit.

The automotive industry uses relays in combination with fuses tremendously in mostly centralized positions in a car. One problem with relays is that undesired arcing may occur between the contacts that may lead the contacts welled shut, or make the relay fail due to the contact surface damage by the destructive arc energy upon switching events. US 7,282,924 discloses an electricity system having an arc for detecting a sub-system including a relay unit, a current sensor, an analog circuit, a digital circuit and a processing unit that is configured to comment the relay unit to disconnect the current in response to identifying arc faults. This raises questions on scalability and flexibility not to mention the cumbersome effort in replacement of fuses. Addition of more functions leads to extra junction boxes and the harness that comes along with it, increasing the weight of the vehicle, leading to higher emissions of C0₂.

US 2016/0203932 A1 relates to an alternating current circuit breaker which includes a first galvanic separation switch and a bypass switch in a live line, and a second galvanic separation switch in a neutral line, and a semiconductor switch element connected parallel to the bypass switch. The semiconductor switch element includes a combination of a rectifier bridge and an isolated gate bipolar transistor (IGBT). A processing unit is connected to a current measurement unit arranged in the live line, and is arranged to control the bypass switch, first and second galvanic separation switches and the conducting state of the IGBT in case of detection of a short circuit condition.

WO 2016/135126 A1 relates to the field of power distribution networks and discloses a digital output circuit, for controlling an item of equipment within a power distribution network, comprises a switch element openable and closeable to selectively permit the flow of current to an item of equipment being controlled in use by the digital output circuit. The digital output circuit also includes a current acquisition circuit to measure the current flowing through the switch element. In addition the digital output circuit includes a condition monitoring circuit that is arranged in communication with the current acquisition circuit. The condition monitoring circuit is configured to record the measured current flowing through the switch element as the switch element closes and thereby establish a switch element closing signature.

US 2012/0293891 A1 discloses a disconnect device for selectively disconnecting a battery from a load including a primary mechanical contact defining a primary current path between the battery and the load. The device further includes a controller generating open and close commands for operating said primary contact, and an electronic switch also operated by the controller. The electronic switch provides a secondary current path to eliminate flashover that may damage the primary mechanical contact.

DE 10 2015 000 567 A1 relates to a switching device for switching an electrical component of a motor vehicle. The switching device has an electrical system connection for connecting the switching device to an electrical system of the motor vehicle, and a component connection for connecting the component to the switching device. The switching device comprises two switching stage units and at least one of each switching stage unit has a semiconductor switch for switching/regulating the current flowing from the power supply through the switching device to the electrical component.

DE 33 45 701 A1 discloses an electrical switching member with a connection plate carrying plug members. The plug members are attached to a base from which a first and a second circuit board extend essentially perpendicularly. The circuit boards are arranged essentially parallel to each other, comprise electrical components and are connected to each other by means of a stamped conductive member.

The increased electric complexity in automobiles puts pressure on electric circuits and electric switches that need to be included in various connectors and fuses. The switches and fuses commonly used in the automotive sector are usually inflexible, merely switched to close and open the load circuit.

An objective of the present invention is thus to provide an electric switch for automotive application that is intelligent, i.e. provides more than one switching function.

The initially mentioned electric switch solves the above problem in that the control unit of the intelligent switch is a microcontroller that is connected to at least one inlet via a power supply line.

By providing an arbitrary combination of at least two switching submodules, including at least one electromechanic and at least one electric switching submodule in the switch circuit of the electric switch, together with a control unit, the electric switch becomes intelligent, thus offering more than one switching function. For example, it can be customized to the needs benefitting e.g. from the fast response and capability of easily resetting an electric switching submodule as well as the advantages of an electromechanic switching submodule, such as for example, a safe switching state after power off. Connecting the microcontroller to the at least one circuit with a power supply line makes the intelligent switch a self-supporting module which gets its power from the load circuit.

In the following, different embodiments of the inventive intelligent switch will be described by way of example, wherein the features of each of the embodiments are advantageous on their own. Technical features of the different embodiments may be arbitrarily combined or omitted if the technical effect achieved by the omitted technical feature is not relevant to the invention.

In one embodiment, the intelligent switch comprises an electric automotive connector comprising a base assembly having at one side thereof a connector face with the at least one inlet and the at least one outlet and having an interior side opposite the connector face, wherein the switch circuit is provided at the interior side. Providing the intelligent switch with an electric connector allows an easy assembly of the automotive switch. Further, separating the connector face with the inlet and outlet, where the intelligent switch is connected to the load circuit on one hand and the switch circuit at the interior on the other hand spatially, provides the switch with a modularity. For example, the switch circuit may be changed according to the requirements of the switch while maintaining the design of the at least one inlet and the at least one outlet at the connector face.

In a further embodiment of the intelligent switch, the at least one electromechanic switching submodule may be a monostable switching submodule or a bistable switching submodule. The electromechanic switching submodule may, for example, be a mono- or bistable relay. A monostable relay has the advantage that it reaches a safe state after power down that keeps the electromechanic switching submodule in one predetermined state, for example in an open state, thus interrupting the load circuit. A bistable electromechanic switching module, such as a bistable relay is advantageous in that it merely requires very low coil power consumption for switching between its two switching (or operating) states.

In a further embodiment, the at least one electric switching submodule may be semi-conductor switch, such as, for example a transistor. Electromechanic switches, in particular, a monostable relay requires manual resetting. Contrary thereto, it is possible to reset a semi-conductor switch remotely. Further, semi-conductor switches allow pulse width modulation, making it possible to control the voltage and current fed through the load path to the load, e.g. a lamp. Further, semi-conductor switches respond very quickly and are a small size, thus allowing to minimize the size of the electric automotive switch/fuse. The quick response allows semi-conductor switches to be used as a soft fuse that disconnects the load before the current reaches values that are too high. The electric switching submodule may be a field-effect transistor that can operate at high voltages, e.g. within a 48 volt power net. Further, field-effect transistors require low power consumption for controlling the switch and may have diagnostic features on board, such as, for example a current, temperature or voltage detector.

According to a further embodiment of the intelligent switch (or fuse: in the following, where embodiments with respect to a switch are described, these encompassing the specific embodiments of the switch being a fuse), the connector face comprises at least 3 terminals. One terminal may represent an inlet, another terminal may represent an outlet, and the third terminal may for example be a control interface or signal outlet. In one embodiment, the connector face is a standardized connector face used in the automotive industry, such as a mini-ISO plug or socket according to DIN 72552, or another socket or plug. In one exemplary embodiment, the switch may have nine terminals. Providing the intelligent switch with nine terminals allows to connect it to more than one load path, namely up to four different load paths, while still having one terminal free for another functionality, such as diagnostic functionality. Due to its modularity, the intelligent switch according to the present invention provides flexibility allowing for customization of the switch circuit to the requirements of the respective path connected thereto. Being able to conduct more than one path, e.g. a load path through the same intelligent switch minimizes the number of components required, thus saving costs and materials.

According to a further embodiment, the intelligent switch according to the present invention may comprise a control unit for controlling an operating state of an operating switching submodule. Providing the intelligent switch with a control unit, that is the microcontroller, onboard, makes an external controller for the electric switch and its switching submodules unnecessary. It allows to connect the intelligent switch of the present invention to a master control, e.g. an electrical control unit in a vehicle. This way, the inventive intelligent switch can directly output a signal indicating an operating state of a certain switching submodule, such as the contact state of said switching submodule, or other diagnostic and protective features, such as for example the under/over voltage, overcurrent, overtemperature, short circuit and the like. The intelligent switch may comprise a single control unit onboard for controlling each of the switching submodules, which minimizes the number of components and thus reduces the size of the switch.

In a further embodiment of an intelligent switch, the control unit may be connected to each of the switching submodules via a driving line. Via said driving line, the microcontroller may control the switching through the respective switching submodule, such as, for example the state of an electromechanic switching submodule or the voltage/current passing through an electric switching submodule. In case of an electromechanic switching submodule, the microcontroller may be connected via a driving line to a relay driver, which brings the respective switching submodule into the state that corresponds to the preset state which is sent as a signal by the microcontroller via the driving line.

In a further embodiment of the intelligent switch, the control unit may comprise at least one control interface for connecting it to a network system located outside of the intelligent switch. One of the terminals of the connector face may be the control interface, for e.g. receiving instruction data from a host (or master) controller, or a predetermined control data defining limit values for the switch. Via the control interface, the intelligent switch may be connected, e.g. via a Bus system, to a master controller.

In one embodiment, the intelligent switch has a control unit comprising a single control interface. The control interface may be connected to or correspond to one of the terminals, thus providing a control inlet and/or outlet. In case the intelligent switch comprises a single control interface only, that is connected to one of the terminals from the connector face, the electric switch may be connected to the control unit via a bus system, such as, for example a LIN bus. A LIN (Local Interconnect Network) is a concept for low cost automotive networks. The LIN is a serial communications protocol which efficiently supports the controller of mechatronics nodes in a distributed automotive application. The properties and advantages of the LIN bus system are that it is a single master with multiple slaves concept that is self synchronizing having a deterministic signal transmission with signal propagation time computer built in advance. It is of low cost and high speed at a single-wire implementation. Due to the single-wire implementation, an embodiment of the electric automotive switch, in which the control unit comprises a single control interface connected to one terminal only, is possible. This allows an embodiment of the electric automotive switch comprising a standardized ISO socket or plug having nine terminals to house up to four different load paths. In this case, the nine terminals may be assigned to four different load inlets, four different load outlets and the control interface which, via a LIN bus, may communicate with a master controller. In this embodiment, using a standard connector face, nevertheless achieves a high degree of flexibility. However, the intelligent switch may likewise comprise more than one control interface and/or more than one control unit. Further, any kind of appropriate communication medium can be implemented including existing automotive communication technologies such as Controller Area Network (CAN), FlexRay (FR), Media Oriented Systems Transport (MOST) and Low Voltage Differential Signaling (LVDS). An advantage of using LIN is that it is a cheaper alternative to the CAN networks usually used for vehicles. LIN systems can be connected to a vehicle CAN network via a LIN/CAN gateway. This reduces the number of devices that need to communicate with the CAN network, eliminating the costs of CAN controllers for each of the switches. LIN complements CAN by being much cheaper and yet supporting the communication needed for typical automotive subsystems.

The power supply line may either connect the control unit to the load input directly, or indirectly via the conductors (or paths) of the switch circuit.

In one embodiment, a diode may be arranged in the power supply line. The diode protects the switch against reverse polarity. The power supply on the control unit may be taken from 2 or more circuits (e.g. load circuits), which can be decoupled by diodes.

In a further embodiment of the present invention, the intelligent switch may have diagnostic functionality by comprising a diagnostic submodule. The diagnostic submodule may comprise at least one sensor for detecting at least one of the operating states of the switching submodule, such as a current, a temperature, a voltage, a contact state, etc... The diagnostic submodule/the sensor may be either onboard the microcontroller, or may be separate from the microcontroller and may be connected to the control unit via a status line. When providing the switch with a contact state sensor, it can detect the contact state of the switching submodule, i.e. whether the switch is on or off. The sensor can output respective information via the status line to the microcontroller, this way providing the intelligent switch with an additional diagnostic function. Accordingly, current sensors and/or voltage sensors may be arranged in the (load) path of the switching circuit from an inlet to an outlet, which sensors may be connected to the microcontroller via status lines and are capable of sending a signal representative for the current, voltage, temperature, or other parameter that is to be monitored to the microcontroller.

The flexibility of the intelligent switch is further improved, according to a further embodiment, in that two switching submodules may be connected in series or parallel, within a load path. For example, an electromechanical switching submodule such as for example a relay, and an electronic switching submodule, such as a semi-conductor, may be connected in parallel, which would improve the lifetime of the relay. Arranging an electromechanic switching submodule and an electric or electronic switching submodule in parallel allows combination of the advantages of both technologies. An electric switching submodule such as a semi-conductor switching submodule switches without wear-out. It takes over the switching process quickly and without contact erosion that may occur at a relay. The electromechanic switching submodule such as a relay has the advantage of lower through-resistance, so it takes over carrying of the continuous current. The advantages of combining both is an increased lifetime of the relay as the semi-conductor switch may bypass the in rush load current and thus reduces the risk of an arching effect in the relay. Consequently, an operation at higher voltages than rated for the concerned relay is possible.

At least two switching subunits may be connected in series. For example, an electromechanic switch, such as a relay and an electric switching submodule, such as a relay may be connected in series providing a redundant protective feature increasing the safety for critical safety application. The redundancy will guarantee that always one switch can disconnect the circuit if the other fails.

In one specific embodiment of the electric switch according to the present invention and at least one terminal for the bus communication, up to a total of 4 switching submodules may be comprised in the switch. Even a switch with 4 switching submodules would be capable of being used together with a standardized ISO plug or socket having nine terminals, such as for example a mini-ISO plug according to DIN 72552. These nine terminals could, for example, be used for various inlets and outlets.

According to a further embodiment, the intelligent switch may comprise at least one circuit board comprising at least one electric or electromechanic component selected from the group of electromechanic switching submodule, control unit, driving line, power line, status line, diode and sensor. Providing the switching circuit or parts of the switching circuit on a circuit board achieves a modularity allowing to easily exchange components of the intelligent switch and furthermore provides a system for customizing the switch to its needs while maintaining standardized structure, for example via a standardized connector face.

According to a further embodiment, at least two circuit board sections may be provided at the interior side which extend away from the basis and then face each other, wherein each circuit board assembly comprises at least one electric component of the switching circuit and/or the control circuit having the control units and its connection lines.

By providing two circuit board sections, the mounting surface of the intelligent switch may be increased up to twice the value of a single circuit board section. The at least two circuit board sections may be connected to the at least one contact element (or terminal) in a series or parallel. The contact board sections may preferentially extend perpendicularly away from the base assembly and the electric components may preferentially be arranged in the space between the at least two contact board sections. This results in an intelligent switch or fuse having an increased mounting surface for receiving electric components without increasing its size prescribed by the applicable standard. This may reduce the overall size of the intelligent switch or connector, wherein the reduction of size refers to those dimensions of the intelligent switch not specified by a minimum value covered or described by the applied standard (the reduction of size is not to be understood as, for instance, a reduction of the length of contact pins or flat connectors).

In a further embodiment, the at least one contact element (which is a synonym for a terminal in the following) is openly accessible from the connector face. Such an openly accessible contact element allows for easy mounting of the electric connector of the switch, e.g. by plugging the electric connector, more precisely the at least one contact element into a plug socket which is complementary to the connector face of the electric connector.

Also, soldering pins for soldering the electric connector for automotive applications to a circuit board are preferably openly accessible for easily mounting the electric connector to the circuit board by soldering.

In another embodiment, at least one electrically conductive element is connected to the at least two circuit board sections. An electrically conductive element is advantageous for establishing an electric connection between the at least two circuit board sections.

The at least two circuit board sections may be galvanically isolated from each other except for the electric connection via the at least one electrically conductive element. An arbitrary number of electrically conductive elements may be provided and may electrically connect the at least two circuit board sections to each other. A plurality of electrically conductive elements may be used to provide a driving current and/or electrically coded signals from one circuit board section to different electric components on the second circuit board section. The electrically conductive elements may also be used to transmit control signals from one circuit board section to the other circuit board section.

In yet another embodiment, an insulating element may connect the at least two circuit board sections. Such an insulating element may be applied to increase the mechanical stability of each of the at least two circuit board sections.

In a further embodiment, the at least one electrically conductive element is arranged substantially parallel to the base assembly. Such an arrangement of the at least one electrically conductive element allows for optimal use of the space between the at least two circuit board sections, which would be decreased by an electrically conductive element arranged diagonally between the at least two circuit board sections. The at least one electrically conductive element may be embodied as an elongated contact member in the form of a pin or may be embodied as a plate arranged and mounted to the at least two circuit board sections.

In another embodiment, the at least two circuit board sections and the electrically conductive element comprise a U-shape.

A U-shape may be obtained if the at least one electrically conductive element is arranged at an end of the circuit board sections located distal to the base assembly. In such an embodiment, the circuit board sections may represent the legs of the U, whereas the at least one electrically conductive element represents the base of the U. As both legs of the U (the at least two circuit board sections) are connected to the base assembly, the overall assembly comprising the at least two circuit board sections and the at least one electrically conductive element has an increased stability and resistivity against vibrations.

In yet another embodiment, a further circuit board section is comprised, which further circuit board section is oriented essentially perpendicular to the at least two circuit board sections.

A further circuit board section may abut the at least two circuit board sections along an edge of the abutting circuit board section, whereas a contact line between the circuit board section may be larger than the contact area of a different electrically conductive element (e.g. a contact pin). Such an increased abutted area increases the stability of the overall assembly of the at least two circuit board sections and the further circuit board section.

The further circuit board section may be oriented parallel to the base assembly and may even more preferably be attached to the at least two circuit board sections at an end of the at least two circuit board sections facing away from the base assembly.

The further circuit board section may also comprise at least one electric component. The further circuit board section may be electrically connected to at least one of the at least two circuit board sections.

By increasing the number of circuit board sections, the available mounting surface may even be increased further.

In another embodiment, the further circuit board section and the at least two circuit board sections form a U-shape. As described above, a U-shape may increase the stability of the overall assembly comprising the at least two circuit board sections and the further circuit board section.

The legs of the U may be formed by the at least two circuit board sections and the base of the U may be formed by the further circuit board section.

In another embodiment, the circuit board sections are embodied on individual circuit boards. Arranging each circuit board section on an individual circuit board may facilitate mounting and unmounting of the electric connector in case of a failure or malfunction, wherein maintenance may also be facilitated by circuit board sections embodied on individual circuit boards. Furthermore, individual circuit boards may be embodied such that a failure of one circuit board section may be compensated for by a second circuit board section which may temporarily replace the faulty circuit board section.

In another embodiment, the further circuit board section comprises at least one of a bearing member and bearing receptacle and at least one of the at least two circuit board sections comprises at least one of a bearing receptacle and a bearing member embodied essentially complementary to the at least one of a bearing member and bearing receptacle of the further circuit board section and in that the at least one bearing member engages in a form-fit with the corresponding bearing receptacle.

The electric automotive switch may be provided with a monolithic circuit board which comprises the at least two circuit board sections. Especially in the case of electric automotive switches or connectors with a small footprint, a monolithically embodied circuit board may facilitate the mounting of the comprised circuit board sections onto the base assembly and/or into a housing of the electric automotive connector, as all circuit board sections may be mounted at once and do not need to be positioned to each other.

The monolithic circuit board may initially comprise the above-described U-shape.

In yet another embodiment, the monolithic circuit board comprises at least one angled section.

The at least one angled section may be preferentially comprised between at least one of the at least two circuit board sections and the further circuit board section. The angled section is preferably arranged at an edge of one circuit board section connecting an edge of another circuit board section. Several angled sections may be comprised in the intelligent switch.

In a further embodiment, the at least one angled section is either bent, or folded, or both.

A bent angled section may comprise a bending radius, whereas a folded angled section comprises a relatively sharp kink of the angled section. The angled section may comprise any angle but is most preferably bent or folded by 90°.

Depending on the material of the angled section, only one of bending or folding may be possible for the corresponding angled section.

In another embodiment, at least one angled section has a locally decreased thickness. A locally decreased thickness may allow for an easy bending of the angled section or may allow for folding the angled section, which may not be suited for folding or bending with an initial thickness.

If a circuit board is considered, bending or folding of such a circuit board is hardly possible with a circuit board of a common thickness of, for instance, several millimeters. Bending such a pristine circuit board would unavoidably result in fractures on the surfaces of the circuit board or even to a breaking of the circuit board if a certain bending angle is achieved.

The locally decreased thickness of the angled section may comprise an increased flexibility as compared to the pristine circuit board.

Reducing the thickness may be achieved by cutting the circuit board, chemically etching, or by shape cutting the angled region. Such techniques are to be understood only as exemplary methods for obtaining an angled section with a locally decreased thickness.

Preferentially, the progression from the initial thickness of the circuit board to the locally decreased thickness occurs in a smooth manner and not with a steep edge as a steep edge increases the danger of fractures and breaking of the circuit board.

In another embodiment, in the region of locally decreased thickness, a circuit board is essentially reduced to at least one metallic layer. A remaining metallic layer has the advantage of being more flexible than a layer of the circuit board material of the corresponding thickness.

The at least one metallic layer preferentially comprises copper, which copper layer may be even more preferably the copper layer of the circuit board applied in the electric automotive connector. The at least one metallic layer may still be covered by a layer of the circuit board material wherein the layer thickness of the circuit board material is preferably below the layer thickness of the at least one metallic layer.

In yet another embodiment, the base assembly and at least one of the at least two circuit boards are arranged to each other in a form-fit. A form-fit during the base assembly and at least one of the at least two circuit boards is advantageous as the available space, in particular the space of the housing of the electric automotive connector, may be used in an optimal way.

The base assembly and the at least one of the two circuit boards may even be arranged in a form-fit connection, i.e. they may be detachably locked to each other. The form-fit between the base assembly and the at least one circuit board may be engaged by a groove.

In the following, the inventive electric automotive connector will be described by way of example with reference to the accompanying figures. Technical features of the individual embodiments described below may be arbitrarily combined or omitted if the technical effect obtained by the omitted technical feature is not relevant to the invention. Same elements or elements with the same technical effect will be labeled with the same reference numerals.

In the figures:
- Fig. 1: shows a schematic representation of an intelligent switch according to a first embodiment;
- Fig. 2: shows a schematic representation of an intelligent switch in a further embodiment;
- Fig. 3: shows a schematic representation of an intelligent switch according to another embodiment;
- Fig. 4: shows an embodiment of the inventive connector in a perspective and side view;
- Fig. 5: shows another embodiment of the inventive electric connector in a perspective and side view;
- Fig. 6: shows another embodiment of the inventive automotive connector in a perspective and side view; and
- Fig. 7: shows another embodiment of the inventive electric connector in a perspective and side view.

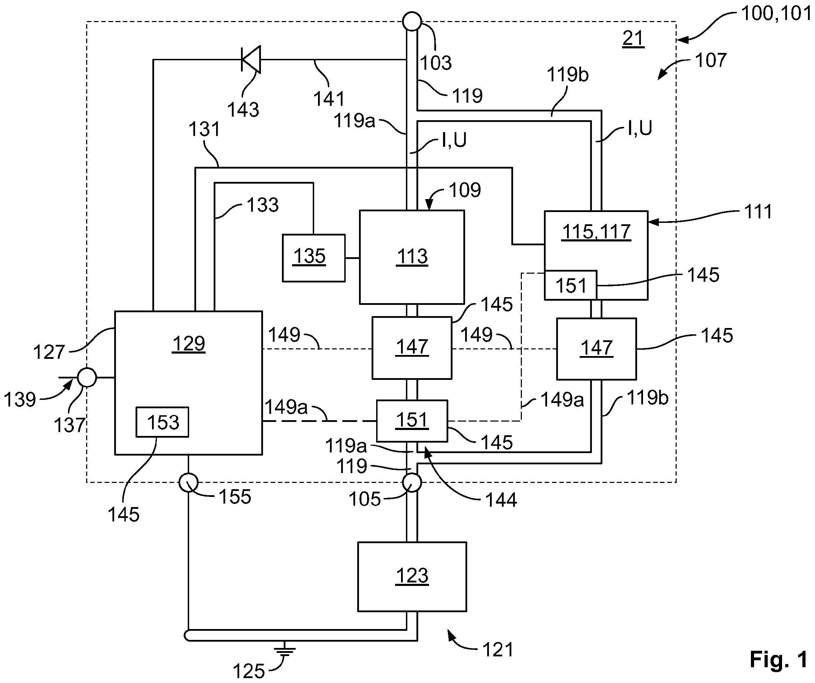

In Fig. 1, a schematic representation of an intelligent switch 100 for automotive applications, in particular, a resettable or programmable fuse 101 is shown.

The intelligent switch 100 comprises at least one inlet 103 and at least one load outlet 105. The inlet 103 may be an input port, e.g. for a load line. The outlet 105 may be an output port, e.g. for a load line. The inlet 103 and the outlet 105 may be a terminal 9 (or contact element), e.g. a contact pin or a contact socket of the intelligent switch 100.

In the first embodiment shown in Fig. 1, the intelligent switch 100, e.g. a resettable and/or programmable fuse 101 comprises exactly one inlet 103 and one outlet 105.

A switch circuit 107 electrically connects the at least one inlet 103 and the at least one outlet 105. The switch circuit 107 comprises at least one electromechanic switching submodule 109 as an electromechanical component 29 and at least one electric switching submodule 111 as an electric component 27.

In the exemplary embodiment shown in Fig. 1, the switch circuit 107 comprises one electromechanic switching submodule 109 and one electric switching submodule 111. The electromechanic switching submodule 109, for example a monostable switching module 113 and the electric switching submodule 111, for example a semi-conductor switch 115 such as a field-effect transistor 117 (e.g. a power MOSFET) are connected in parallel in the switch circuit 107. That is, the switch circuit 107 comprises, after the inlet 103, a path 119 which is divided into two subpaths 119a, 119b. The monostable switching submodule 113, e.g. a monostable relay is arranged in the subpath 119a. The semi-conductor switch 115 is arranged in the subpath 119b. After the electromechanic switching submodule 109 and the electric switching submodule 111, the first subpath 119a and the second subpath 119b are combined before the path 119 is finally connected to the outlet 105.

The circuit 121 in the shown embodiment comprises, in addition to the intelligent switch 100 or fuse 101, an electric load 123 which is led to ground 125 of, e.g. an automotive (not shown) in the case of using the switch 100 for an automotive application.

The intelligent switch 100 in the embodiment shown in Fig. 1 further comprises a control unit 127, such as for example a microcontroller 129, for controlling an operating state of the switching submodules 109, 111. In the monostable switching submodule 113, the operating state may for example be "on" or "off', i.e. the relay is either closed ("on") and thus connects the paths 119 from the inlet 103 to the outlet 105 via subpath 119a, or is "off', i.e. disconnecting the path 119. In the electric switching submodule 111, the operating state may likewise be either "on" or "off", or corresponds to a certain value of current fed to the load 123 via pulse width modulation, thus enabling a variation of output voltage.

The control unit 127 is connected to the electromechanic switching submodule 109 via a driving line 131 and to the electric switching submodule 111 via another driving line 133. In case of monostable relays used as a monostable switching module 113, the driving line 133 connects the microcontroller 129 to a driver, here a relay driver 135. The driver 135 acts on the switching monostable switching module 113 and, upon receiving a corresponding signal from the control unit 127 via the driving line 133, brings the electromechanic switching submodule 113 into a certain operating state, commonly the "off"-state, in which it interrupts the path 119.

The control unit 127 comprises a control interface 137 for connecting the control unit 127 to a network system (not shown in detail) located outside of the intelligent switch 100. In the embodiment shown in Fig. 1, the intelligent switch 100 comprises a single control interface 137. In the shown embodiment, the control interface 137 is one terminal 9 in a connector 1 (not shown in Fig. 1) of the intelligent switch 100.

The control interface 137 may be connected to a bus system 139 for connecting the control unit 127 of the intelligent switch 100 to a master controller, e.g. an engine or electric control unit (not shown) of an automobile. The bus system 139 may be, for example a LIN bus, or any other preferably single-wire network allowing to send data from a master controller to the control unit 127 of the intelligent switch 100 or sending information about the intelligent switch 100 from its control unit 127. However, other existing communication technologies, like a Controller Area Network (CAN), FlexRay, Media Oriented Systems Transport, and Low Voltage Differential Signaling, may also be used.

The fuse 101, in the embodiment shown in Fig. 1, is a self-supporting module that does not require a separated power connection. The intelligent switch 100 withdraws its power from the path 119. To do so, the control unit 127 is connected to the inlet 103 via a power-supply line 141. In the shown embodiment, an overvoltage protection 143, e.g. a diode, is arranged in the power-supply line 141 and thus avoiding damaging the microcontroller 129. In the shown embodiment, the control unit 127 is further connected to a ground terminal 155.

In the embodiment shown in Fig. 1, the intelligent switch 100 comprises a diagnostic submodule 144. The diagnostic submodule 144 comprises at least one sensor 145 for detecting at least one of the operating state of the switching submodule 109, 111, a path current I, a temperature T, and a voltage U. In the shown embodiment, an contact state monitor 147 is arranged in each of the subpaths 119a, 119b. Via a status line 149, the contact state monitors 147 are connected to the control unit 127. The operating state of the switching submodule 109, 111, detected by the contact state monitors 147, may be outputted to the control unit 127 via the status line 149.

The intelligent switch 100 in the embodiment shown in Fig. 1, further comprises a current sensor 151 in the first subpath 119a detecting the current I in said subpath 119a. The current may be continuously monitored by a HALL-effect current sensor. Via a further status line 149a, data representing the current I in the subpath 119b may be transmitted from the current sensor 151 to the control unit 127. The electric switching submodule 111, in the embodiment shown in Fig. 1, may be a so-called smart FET 117, that is a semi-conductor switch 115 on the basis of a field-effect transistor 117, which furthermore comprises onboard a diagnostic device, such as a current sensor 151, thus combining protective and diagnostic features. The current sensor 151 of the smart FET 117 is also connected via a status line 149a to the control unit 127.

The intelligent switch 100 further comprises a temperature sensor 153. In the shown embodiment, the temperature sensor 153 is an internal temperature sensor of the microcontroller 129.

In summary, the intelligent switch 100 comprises sensors 145 that are capable of detecting the operating state of the switching submodules 109, 111, the current, and consequently the voltage in the subpath 119a and 119b as well as the temperature. The microcontroller 129 may thus receive data concerning the contact state of the switching submodules 109, 111, the current and/or voltage in the subpath 119a and 119b and the temperature in the switch 100. Based on the respective data received from the sensors 145 via the status lines 149, 149a, the control unit 127 may decide for example, whether there is an overload, an overvoltage, a short circuit, or thermal stability. In case there is no malfunction, i.e. no overload, no overvoltage, no short circuit and thermal stability, the control unit 127 may send a status to the master controller of the automotive via the bus system 139 connected to the control interface 137. In case of a malfunction, e.g. an overload, overvoltage, short circuit or thermal instability, the control unit 127 may take the appropriate measures by sending data via driving lines 131, 133 for accordingly changing the operating state of its switching modules 109, 111, e.g. opening the monostable relay, thus interrupting the path 119.

The switch circuit 107 of the first embodiment shown in Fig. 1 may be on board a circuit board 21. In the shown embodiment, all electric components 27 and electromechanical components 29 of the switch circuit 107 are in a single circuit board 21.

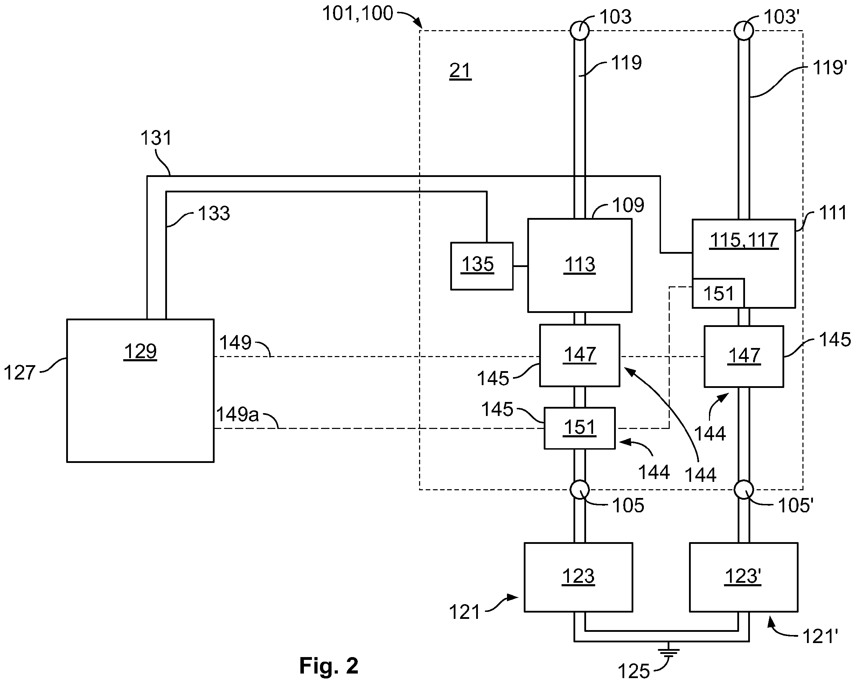

Fig. 2 shows another embodiment of the intelligent switch 100 for automotive applications, which may also be embodied as a resettable and/or programmable fuse 101.

In the following, only the differences of the embodiment of the intelligent switch 100 shown in Fig. 2, compared to the embodiment shown in Fig. 1 will be described.

The intelligent switch 100 of the embodiment shown in Fig. 2 comprises a first path 119 and a second path 119'. Accordingly, the intelligent switch 100 comprises two inlets 103, 103', and two outlets 105, 105'. In the first path 119, an electromechanic switching submodule 109, e.g. a monostable switching submodule 113/electric switching submodule 111 is arranged, the operating state of which may be changed via a driver 135. Similar to the embodiment shown in Fig. 1, a contact state monitor 147 and a current sensor 151 are arranged in the path 119.

In the second path 119', an electric switching submodule 111 is arranged, as well as a contact state monitor 147 that is capable of detecting and outputting the operating state of the electric switching submodule 111. Circuits 121, 121' comprising the first path 119 and the second path 119' respectively, each comprise a different load 123, 123' that is connected to the ground 125 of e.g. an automobile.

The intelligent switch 100 of the embodiment shown in Fig. 2 differs from the embodiment shown in Fig. 1 in that the control unit 127 is not onboard the intelligent switch 100, but a separate unit outside of the switch 100. The control unit 127 controls the switching submodules 109, 111 via driving lines 131, 133, connecting the control unit 127 to the electric switching submodule 111 directly and via the driver 135 to the electromechanic switching submodule 109. Further, status lines 149, 149a connect the control unit 127 to the sensors 145 of the intelligent switch 100.

In the embodiment shown in Fig. 2, the intelligent switch 100, e.g. an electric fuse 101, may act on two different paths 119, 119' for two different loads 123, 123'.

In a further alternative, which is not shown in the figures, instead of having two separate paths 119, 119', the electromechanic switching submodule 109 and the electric switching submodule 111 may be arranged in series in the same path. This could be achieved, e.g. by connecting the outlet 105 shown in Fig. 2 to the inlet 103' and removing the load 123. Such an embodiment may be advantageous for critical loads, for which a redundancy in the fuse function achieved by connecting the switching submodules 109 and 111 in series. This further alternative thus enhances the safety. It makes the switch-off events more reliable by using two switching submodules in series.

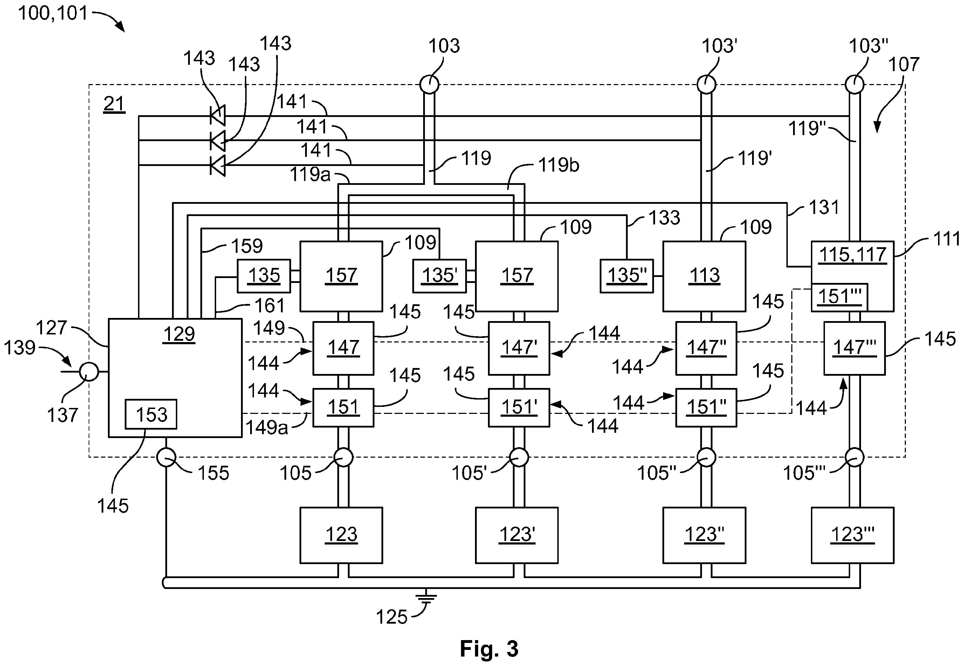

In Fig. 3, another embodiment of an intelligent switch 100 according to the present invention is shown schematically. The switch circuit 107 is designed to be connected to nine terminals 9 and comprises three inlets 103, 103', 103", four outlets 105, 105', 105", 105"', one ground terminal 155 and a control interface 137. Similar to the embodiments shown in Fig. 1, the intelligent switch 100 of the embodiment shown in Fig. 3 comprises all electric components 27 as well as all electromechanical components 29 onboard the circuit board 21.

In the embodiment shown in Fig. 3, the intelligent switch 100 is capable of handling three paths 119, 119', 119". Similar to the embodiments shown in Fig. 2, a monostable electromechanical switching submodule 109 is arranged in one path 119' corresponding to paths 119 in Fig. 2 and in another path 119", an electric switching submodule 111 is arranged, which principally corresponds to path 119" in Fig. 3. A further path 119 comprises two electromechanic switching submodules 109 arranged in parallel. In the embodiment shown in Fig. 3, these electromechanic switching submodule/subunits 109 are bistable switching subunits/submodule 157, which are driven by respective drivers 135, 135'. In contrast to a monostable switching submodule 113, a bistable switching submodule 157 may obtain two distinct states, which is indicated in the two lines drawn from the respective driver 135, 135' to its corresponding bistable switching submodule 157. The drivers 135, 135' are connected to the control unit 127 via driving lines 159, 161.

Of course, in alternative embodiments, arbitrary combinations of switching submodules are possible. For example, the design shown in Fig. 3 may be varied so far as an electric switching submodule 111 may be connected in parallel with an electromechanical switching submodule in further path 119, and two electromechanic switching submodules 109, e.g. one bi-stable relay and mono-stable relay, may be arranged in paths 119' and 119", respectively.

Arranging an electromechanic switching submodule 109 and an electric switching submodule 111 in parallel in one path allows use of the intelligent switch 100 as an age-booster solution for the electromechanic switching submodule 109. One problem with electromechanical relays is the undesired arcing between the contacts. The undesired arching might eventually lead the contacts shut, or make the relay fail due to the contact surface damage by the destructive arc energy upon switching events. The embodiment using a parallel combination of electric switching submodule 111, e.g. a power MOSFET, and an electromechanic switching submodule 109, such as a relay reduces the undesired arcing. For switching the load, first the electric switching submodule 111 switches on, and then the electromechanic switching submodule 109 takes over. This helps by passing the in-rush current through the electric switching submodule 111 and reduces the arcing effect on the contacts of the electromechanic switching submodule 109.

Although the control unit 127 is shown in the embodiments of Figs. 1 to 3 as a single unit, the intelligent switch 100 may either comprise more than one, e.g. two separate control units (embodiment not shown). The separate control units may communicate and control different submodules 109, 111 of the switch 100. Further, they may communicate with each other. For example, one first control unit may comprise the input of a bus system and the output of the first control unit may be connected to the input of the second control unit. The output of the second control unit in turn, is the output of the intelligent switch 100 in the bus system, connecting this switch 100 to another switch or the master.

The intelligent switch 100 shown schematically in Figs. 1 to 3 or any other embodiment thereof may comprise an electrical connector 1 comprising a base assembly 11 having at one side thereof a connector face 7 comprising terminals 9 or contact elements which may correspond to or may be electrically connected to the inlet 103, the outlet 105, the control interface 137 of the control unit 127 or the ground terminal 155.

The electric connector 1 with the base assembly 11 may have an interior side 17 opposite the connector face 7, at which the switch circuit 107 is provided. As will be shown in the following, the connector face 7 may comprise at least three terminals 9, but preferably comprises the connector face having nine terminals 9.

As will be explained in detail below, the intelligent switch 100 for automotive application may comprise at least two circuit board sections 19 that are provided at the interior side 17 which extend away from the base assembly 11 and face other, wherein each of the at least two circuit board sections 19 comprises at least one electric 27/or electromechanic component 29 of the switch circuit 107.

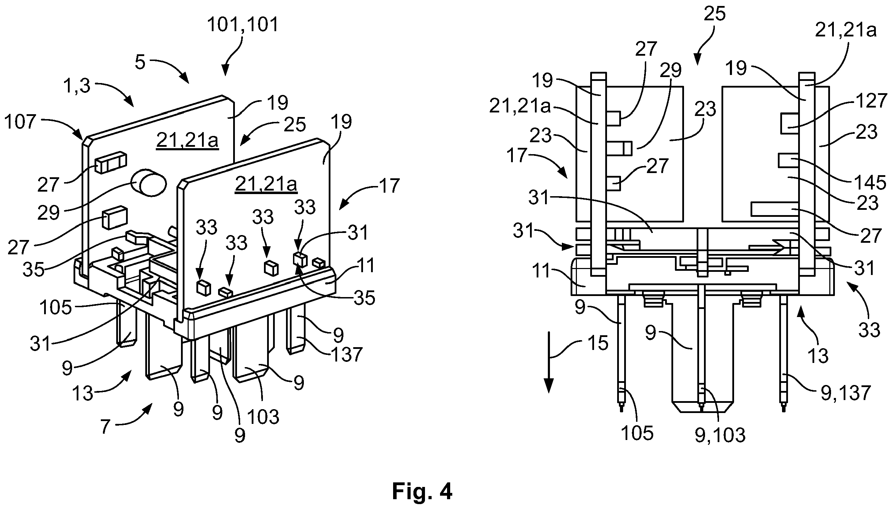

In Fig. 4, an embodiment of the inventive intelligent switch 100 is shown. The switch 100 comprises an electric connector 1 shown in Fig. 4 is embodied as a fuse 101 or relay 3 in a plug-in form 5.

The plug-in form 5 is characterized by a connector face 7 which comprises a multitude of contact elements or terminals 9. The electric connector 1 further comprises a base assembly 11 which receives the terminals 9.

The contact elements or terminals 9 extend from the base assembly 11 to a connector side 13 in a connector direction 15. Along the connector direction 15 the electric connector 1 of the intelligent switch 100 may be plugged into a corresponding plug socket provided for instance in a car.

Opposite to the connector face 7, the electric connector 1 comprises an interior side 17 on which two circuit board sections 19 are provided which extend away from the base assembly 11.

The two circuit board sections 19 are oriented essentially perpendicular to the base assembly 11 and parallel to each other. The two circuit board sections 19 are each embodied on a circuit board 21, wherein the circuit boards 21 shown in the embodiment of Fig. 4 are individual circuit boards 21a. The circuit boards 21a or the circuit board sections 19 comprise the electric 27 and electromechanic 29 components of the switch current 107.

Each of the individual circuit boards 21a defines a mounting volume 23 which faces towards a space 25 between the circuit boards 21 and a mounting volume 23 which faces away from said space 25. The mounting volumes 23 are indicated in Fig. 4 by rectangles.

Within the mounting volumes 23, each of the circuit board sections 19 may comprise at least one electric component 27 or electromechanic component 29 of the switch current 107 illustrated in Fig. 4 by two exemplary electric components 27.

Fig. 4 further shows transmitting elements 31 which are located and/or attached to the interior side 17 of the base assembly 11 and which are either connected to or monolithically embodied with the contact elements 9. The transmitting elements 31 are mechanically and electrically connected to the individual circuit boards 21a via through hole technology 33, i.e. the transmitting elements 31 are inserted through holes 55 in the individual circuit boards 21a and subsequently soldered to said individual circuit boards 21a. The transmitting elements 31 transmit electric signals and/or power supply voltages from the terminals 9 to the electric components 27 or electromechanical components 29 arranged on the individual circuit boards 21a.

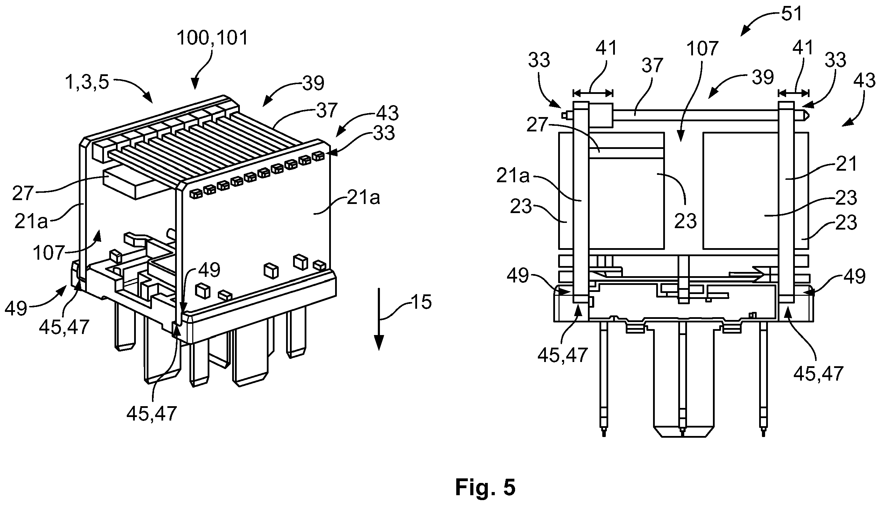

For reasons of visibility, the mechanic connection between the base assembly 11 and the circuit boards 21 will be explained with reference to Fig. 5.

Fig. 5 shows a second embodiment of the electric connector 1 for automotive applications, which is also embodied in the plug-in form 5.

The basic assembly of the second embodiment shown in Fig. 5 is essentially the same as for the first embodiment of Fig. 4, whereas in the second embodiment a multitude of electrically conductive elements 37 (only one of the electrically conductive elements 37 is provided with a reference numeral) connect the two individual circuit boards 21a.

The electrically conductive elements 37 are attached to the individual circuit boards 21a via through hole technology 33. An established electric connection 39 allows for transmission of electrically coded data and/or supply voltages from one individual circuit board 21a to another individual circuit board 21a.

The electrically conductive elements 37 also mechanically stabilize the individual circuit boards 21a by preventing or at least reducing vibrations of the individual circuit boards 21a along a vibration direction 41 indicated by a double-headed arrow.

The individual circuit boards 21a and the electrically conductive elements 37 are arranged in a U-shape 43.

Fig. 5 furthermore shows that the two individual circuit boards 21a are received in a form-fit member 45 arranged at the interior side 17 of the base assembly 11. The form-fit member 45 is embodied as a groove 47. The two individual circuit boards 21a are partially received within the two grooves 47 opening towards the interior side 17 such that each groove 47 engages in a form-fit 49 with the corresponding individual circuit board 21a.

The individual circuit boards 21a may be loosely received in the grooves 47, may be press-fit into the grooves 47 or may be mechanically clamped or fixed to the groove 47 by appropriate fixation means (e.g. a screw, which is not shown in Fig. 5).

The second embodiment of the inventive electric connector 1 shown in Fig. 5 comprises similar mounting volumes 23 as the first embodiment of Fig. 4, whereas the dimension of the mounting volumes 23 in a direction opposite to the connector direction 15 is slightly reduced due to the electrically conductive elements 37.

The electrically conductive elements 37 of the second embodiment shown in Fig. 5, however, may protect electric components 27 from being accessed from an upper side 51.

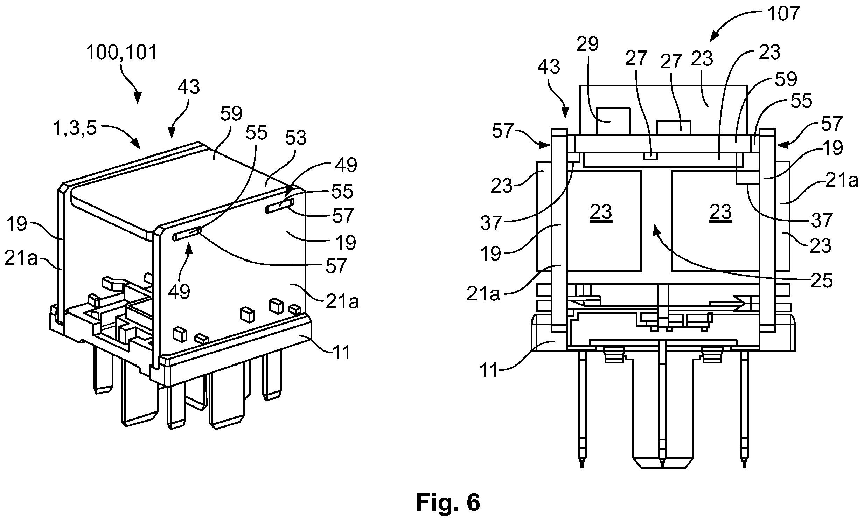

Fig. 6 shows a third embodiment of the inventive electric connector 1 which is also embodied as a relay 3 in the plug-in form 5.

This third embodiment comprises a further circuit board section 53 which is attached to the two circuit board sections 19 by four bearing members 55, which extend away from the further circuit board section 53 and are received in bearing receptacles 57 embodied in the two individual circuit boards 21a at a side thereof distal to the base assembly 11.

The bearing receptacles 57 and the bearing members 55 engage with each other in a form-fit 49, i.e. the bearing members 55 abut the interior of the bearing receptacles 57, which detachably receive the bearing members 55. The bearing members 55 and the bearing receptacles 57 are essentially complementary to each other.

In the embodiment of the electric connector 1 shown in Fig. 6, the bearing members 55 do not extend in the space 25 or out of the bearing receptacles 57 of the individual circuit boards 21a.

The further circuit board section 53 is arranged on a further circuit board 59 which is oriented essentially perpendicular to the individual circuit boards 21a and essentially parallel to the base assembly 11.

The further circuit board 59 defines additional mounting volumes 23 in which further electric 27 or electromechanic components 29 may be mounted to the further circuit board 59.

The further circuit board 59 may be electrically connected to at least one of the individual circuit boards 21a by an electrically conductive element 37 which is exemplarily shown in Fig. 6 in the form of an angled electrically conductive element 37.

Also, in the embodiment of the inventive intelligent switch 100 for automotive applications shown in Fig. 6, the individual circuit boards 21a and the further circuit board 59 form a U-shape 43.

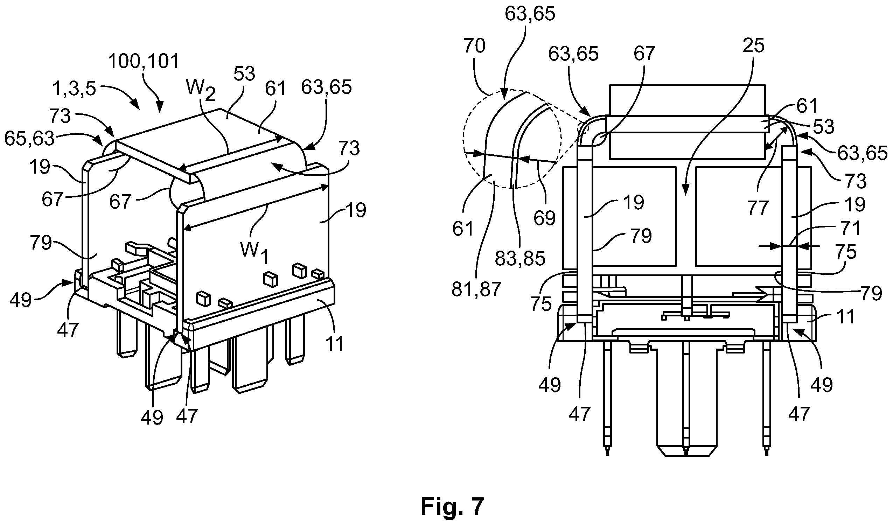

Fig. 7 shows a fourth embodiment of the inventive electric connector 1 , which is also embodied in the plug-in form 5.

Contrary to the three embodiments shown in Figs. 4 to 6, this embodiment of Fig. 7 does not comprise individual circuit boards 21a, but is formed by a monolithic circuit board 61.

The monolithic circuit board 61 comprises two circuit board sections 19 which are essentially oriented perpendicular to the base assembly 11 and essentially parallel to each other, and a further circuit board section 53 which is essentially oriented perpendicular to the two circuit board sections 19 and essentially parallel to the base assembly 11.

The ends of the monolithic circuit board 61 are received in the grooves 47 of the base assembly 11 and are engaged in a form-fit 49 therewith.

Between each of the two circuit board sections 19 and the further circuit board section 53, an angled section 63 is comprised.

In the embodiment shown in Fig. 7, the circuit board sections 19 have a CBS-width w₁ which is larger than a top-width w₂ of the further circuit board section 53. The angled sections 63 extend along the further circuit board sections 53 having the same top-width w₂.

The angled sections 63 of the embodiment shown in Fig. 7 are bent sections 65 but may also be folded sections (not shown) in possible different embodiments.

The bent sections 65 result in a bending angle 67 between each of the two circuit board sections 19 and the further circuit board section 53. The bending angle 67 is approximately a right angle of 90°.

The angled sections 63 comprise a decreased thickness 69 (shown in zoom 70), which is smaller than the circuit board thickness 71. This decreased thickness 69 results in an increased flexibility 73 of the angled sections 63.

The angled sections 63 are located at side walls 75 of the electric automotive connector 1 facing away from the space 25 in between the circuit board sections 19 and the further circuit board section 53. This solution has the advantage that a bending radius 77 of the angled sections 63 is larger than the bending radius 77 obtainable if the angled sections 63 are located at inner walls 79 of the intelligent switch 100. An increased bending radius 77 reduces the risk of fractures and/or severe damage respectively to the angled sections 63.

In the zoom 70 of Fig. 7, the detailed structure of the angled section 63 is depicted. In the region of decreased thickness 69, the monolithic circuit board 61 is thinned such that a metallic layer 81 and a residual layer 83 of circuit board material 85 remain. The metallic layer is preferentially a copper layer 87.

Although an electric component 27 is only shown in Figs. 4 and 5, electric components 27 may also be comprised in the embodiments of Figs. 3 and 4. The technical features described in the first embodiment of the inventive electric connector 1 may be found in the subsequently described embodiments of Figs. 5, 6 and 7 and have not been repeated for the sake of brevity. For simplification, not all electric components 27 and electromechanic components 29 of the switch current 107 are shown in Figs. 4 to 7. Hence, the conduits of the path 119 are omitted in Figs. 4 to 7.

The entire intelligent switch 100 may be comprised in a connector housing, which is not shown in the figures but commonly applied for the electric connectors 1 shown herein.

The footprint of the embodiments shown in Figs. 4 to 7 is defined by the according standard used for the electric automotive connectors 1. The exemplary standard of the four embodiments shown is the mini ISO plug-in type standard for e.g. automotive relays or fuses. The arrangement and size of the contact elements 9 may be found in the German DIN standard DIN 72552.

An intelligent switch for automotive applications of the present invention module that has a combination of switching submodules (e.g. two bi-stable, one monostable and a Smart FET), offers more than one switching function in a single case. The parallel use of switches enables space and weight optimized architectures. Any other electrical combination of the included switching submodules increases functional safety. In addition to the electrical contacts for power signals, the inventive switch may be independently controlled by a 4-pin LIN bus interface that provides direct communication with vehicle ECU. This introduces highest flexibility for the control architecture thereby addressing the need of de-centralized modules.

The present invention thus incorporates different protections such as those against over-voltage and reverse battery polarity, and diagnostic functions may be included as well. It can therefore represent the functionality of a fuse, since it disconnects the load in case of anomalies such as short circuit or overvoltage conditions. It enables any power distribution and control architectures in future vehicles.

The inventive intelligent switch not only helps reducing the number of control wires, it also offers a compact shape that is compatible with the existing platforms. It transforms a simple switching element (i.e. an electromechanical relay) to an intelligent device that has more than one switching function, and may, in certain embodiments, additionally communicate with its commander-unit and provide information about its status and conditions. Based on different scenarios (e.g. software implemented in the control unit), it can also take decisions on its own, even before the ECU handles a fault event.

This switch has a flexible and modular architecture/hardware. Thus, based on customers' preferences, different generics with different number/type of the switching elements inside the module can be developed with minor - mainly software - modifications. Besides, the automatic node-addressing makes this switch quite robust for the repair and maintenance. No extra addressing modification is required for a replacement module.

### REFERENCE NUMERALS

- 1: electric connector
- 3: relay
- 5: plug-in form
- 7: connector face
- 9: contact element
- 11: base assembly
- 13: connector side
- 15: connector direction
- 17: interior side
- 19: circuit board section
- 21: circuit board
- 21a: individual circuit board
- 23: mounting volume
- 25: space
- 27: electric component
- 29: electromechanic component
- 31: transmitting element
- 33: through hole technology
- 35: hole
- 37: electrically conductive element
- 39: electric connection
- 41: vibration direction
- 43: U-shape
- 45: form-fit member
- 47: groove
- 49: form-fit
- 51: upper side
- 53: further circuit board section
- 55: bearing member
- 57: bearing receptacle
- 59: further circuit board
- 61: monolithic circuit board
- 63: angled section
- 65: bent section
- 69: decreased thickness
- 70: zoom
- 71: circuit board thickness
- 73: flexibility
- 75: side walls
- 77: bending radius
- 79: inner wall
- 81: metallic layer
- 83: residual layer
- 85: circuit board material
- 87: copper layer
- 100: intelligent switch
- 101: fuse
- 103, 103', 103": inlet
- 105, 105', 105", 105": outlet
- 107: switch circuit
- 109: electromechanic switching submodule
- 111: electric switching submodule
- 113: monostable switching submodule
- 115: semi-conductor switch
- 117: field-effect transistor
- 119: path
- 119a, 119b: subpath
- 121: circuit
- 123: load
- 125: ground
- 127: control unit
- 129: microcontroller
- 131: driving line
- 133: driving line
- 135: driver
- 137: control interface
- 139: bus system
- 141: power supply line
- 143: over-voltage protection
- 144: diagnostic submodule
- 145: sensor
- 147: contact state monitor
- 149,149a: status line
- 151: current sensor
- 153: temperature sensor
- 155: ground terminal
- 157: bistable switching submodules
- 159: driving line
- 161: driving line

- I: path current
- T: Temperature
- V: Voltage
- w₁: CBS-width
- w₂: top-width

## Claims

1. Intelligent switch (100), in particular a fuse (101), comprising at least one inlet (103, 103', 103"), at least one outlet (105, 105', 105", 105"') and a switch circuit (107) electrically connecting the at least one inlet (103, 103', 103") and the at least one outlet (105, 105', 105", 105"'), wherein the switch circuit (107) comprises at least two switching submodules selected from the list of an electromechanic switching submodule (109) and an electric switching submodule (111), wherein the switch circuit (107) comprises at least one electromechanic switching submodule (109) and at least one electric switching submodule (111), and wherein the switch further comprises a control unit (127) for controlling an operating state of the at least two switching submodules (109, 111) **characterized in that** that the control unit (127) is a microcontroller that is connected to the at least one inlet (103, 103', 103") via a power supply line (141).

2. Intelligent switch (100) according to claim 1, **characterized in that** at least two switching submodules are connected in series or parallel in the switch circuit (107).

3. Intelligent switch (100) according to claim 1 or 2, **characterized in that** the electromechanic switching submodule (109) is a monostable switching submodule (113) or a bistable switching submodule (157).

4. Intelligent switch (100) according to any one of claims 1 to 3, **characterized in that** the electric switching submodule (111) is semi-conductor switch (115), preferably a field-effect transistor (FET) (117) or smart FET.

5. Intelligent switch (100) according to any one of claim 1 to 4, **characterized in that** the control unit (127) comprises at least one control interface (137) for connecting the control unit (127) to a network system located outside the intelligent switch (100).

6. Intelligent switch (100) according to any one of claims 1 to 5, **characterized in that** the control unit (127) is connected to each of the switching submodules (109, 111) via a driving line (131, 133, 159, 161).

7. Intelligent switch (100) of any one of claims 1 to 6, **characterized in that** the switch (100) comprises a diagnostic submodule (144).

8. Intelligent switch (100) according to claim 7, **characterized in that** the diagnostic submodule (144) comprises at least one sensor (145) for detecting at least one of the operating state of a switching submodule, a path current, a temperature, and a voltage.

9. Intelligent switch (100) according to claim 8, **characterized in that** the at least one sensor (145) is connected to the control unit (127) via a status line (149, 149a).

10. Intelligent switch (100) according to any one of claims 1 to 9, **characterized by** an electrical automotive connector (1) comprising a base assembly (11) having at one side thereof a connector face (7) with the at least one inlet (103, 103', 103") and the at least one outlet (105, 105', 105", 105"') and having an interior side (17) opposite to the connector face (7), wherein the switch circuit (107) is provided at the interior side (17).

11. Intelligent switch (100) according to claim 10, **characterized in that** the connector face (7) comprises at least three terminals (9), preferably the connector face (7) comprises a socket or plug having nine terminals.

12. Intelligent switch (100) according to claim 10 or 11, **characterized in that** the control unit (127) comprises a single control interface (137) that is preferably connected to or corresponds to one of the terminals (9).

13. Intelligent switch (100) according to any one of claims 1 to 12, **characterized by** at least one circuit board (21) comprising at least one electric (27) or electromechanic component (29) selected from the group of electromechanic switching submodule (109), electric switching submodule (111), control unit (127), driving line (131, 133, 159, 161), power supply line (141), status line (149, 149a) and sensor (145).

14. Intelligent switch (100) according to claim 13, **characterized in that** at least two circuit board sections (18) are provided at the interior side (17) which extend away from the base assembly (11) and face each other, wherein each circuit board section (19) comprises at least one electric component (27) or electromechanic component (29).

## Patentansprüche

1. Intelligenter Schalter (100), insbesondere eine Sicherung (101), mit mindestens einem Eingang (103, 103', 103"), mindestens einem Ausgang (105, 105', 105", 105'") und einem Schaltschaltkreis (107), der den mindestens einen Eingang (103, 103', 103") und den mindestens einen Ausgang (105, 105', 105", 105'") elektrisch verbindet, wobei der Schaltschaltkreis (107) mindestens zwei Schaltuntermodule aufweist, die ausgewählt sind aus einem elektromechanischen Schaltuntermodul (109) und einem elektrischen Schaltuntermodul (111), wobei der Schaltschaltkreis (107) mindestens ein elektromechanisches Schaltuntermodul (109) und mindestens ein elektrisches Schaltuntermodul (111) aufweist, und wobei der Schalter ferner eine Steuereinheit (127) zur Steuerung eines Betriebszustands der mindestens zwei Schaltuntermodule (109, 111) aufweist,
**dadurch gekennzeichnet, dass**
die Steuereinheit (127) eine Mikrosteuerung ist, die über eine Leistungsversorgungsleitung (141) mit dem mindestens einen Eingang (103, 103', 103") verbunden ist.

2. Intelligenter Schalter (100) nach Anspruch 1, **dadurch gekennzeichnet, dass** mindestens zwei Schaltuntermodule in dem Schaltschaltkreis (107) in Reihe oder parallel geschaltet sind.

3. Intelligenter Schalter (100) nach Anspruch 1 oder 2, **dadurch gekennzeichnet, dass** das elektromechanische Schaltuntermodul (109) ein monostabiles Schaltuntermodul (113) oder ein bistabiles Schaltuntermodul (157) ist.

4. Intelligenter Schalter (100) nach einem der Ansprüche 1 bis 3, **dadurch gekennzeichnet, dass** das elektrische Schaltuntermodul (111) ein Halbleiterschalter (115), vorzugsweise ein Feldeffekttransistor (FET) (117) oder ein intelligenter FET, ist.

5. Intelligenter Schalter (100) nach einem der Ansprüche 1 bis 4, **dadurch gekennzeichnet, dass** die Steuereinheit (127) mindestens eine Steuerschnittstelle (137) zur Anbindung der Steuereinheit (127) an ein Netzwerksystem aufweist, das außerhalb des intelligenten Schalters (100) liegt.

6. Intelligenter Schalter (100) nach einem der Ansprüche 1 bis 5, **dadurch gekennzeichnet, dass** die Steuereinheit (127) mit jedem der Schaltuntermodule (109, 111) über eine Ansteuerleitung (131, 133, 159, 161) verbunden ist.

7. Intelligenter Schalter (100) nach einem der Ansprüche 1 bis 6, **dadurch gekennzeichnet, dass** der Schalter (100) ein Diagnoseuntermodul (144) aufweist.

8. Intelligenter Schalter (100) nach Anspruch 7, **dadurch gekennzeichnet, dass** das Diagnoseuntermodul (144) mindestens einen Sensor (145) zur Erfassung des Betriebszustands eines Schaltuntermoduls, und/oder eines Leitungsstroms und/oder einer Temperatur und/oder einer Spannung aufweist.

9. Intelligenter Schalter (100) nach Anspruch 8, **dadurch gekennzeichnet, dass** der mindestens eine Sensor (145) über eine Statusleitung (149, 149a) mit der Steuereinheit (127) verbunden ist.

10. Intelligenter Schalter (100) nach einem der Ansprüche 1 bis 9, **gekennzeichnet durch** einen elektrischen Automotiv-Verbinder (1) mit einer Basisanordnung (111), die auf einer Seite eine Verbinderfläche (7) mit dem mindestens einen Eingang (103, 103', 103") und dem mindestens einen Ausgang (105, 105', 105", 105"') und eine Innenseite (17) gegenüberliegend zu der Verbinderfläche (7) hat, wobei der Schaltschaltkreis (107) an der Innenseite (17) vorgesehen ist.

11. Intelligenter Schalter (100) nach Anspruch 10, **dadurch gekennzeichnet, dass** die Verbinderfläche (7) mindestens drei Anschlüsse (9) aufweist, wobei vorzugsweise die Verbinderfläche (7) einen Sockel oder einen Steckanschluss mit neun Anschlüssen aufweist.

12. Intelligenter Schalter (100) nach Anspruch 10 oder 11, **dadurch gekennzeichnet, dass** die Steuereinheit (127) eine einzige Steuerschnittstelle (137) aufweist, die vorzugsweise mit einem der Anschlüsse (9) verbunden oder diesem zugeordnet ist.

13. Intelligenter Schalter (100) nach einem der Ansprüche 1 bis 12, **gekennzeichnet durch** mindestens eine Leiterplatte (21) mit mindestens einer elektrischen (27) oder einer elektromechanischen Komponente (29), die ausgewählt ist aus der Gruppe: elektromechanisches Schaltuntermodul (109), elektrisches Schaltuntermodul (111), Steuereinheit (127), Ansteuerleitung (121, 133, 159, 161), Leistungsversorgungsleitung (141), Statusleitung (149, 149a) und Sensor (145).

14. Intelligenter Schalter (100) nach Anspruch 13, **dadurch gekennzeichnet, dass** mindestens zwei Leiterplattenabschnitte (18) an der Innenseite (17) vorgesehen sind, die sich von der Basisanordnung (11) weg erstrecken und einander zugewandt sind, wobei jeder Leiterplattenabschnitt (19) mindestens eine elektrische Komponente (27) oder eine elektromechanische Komponente (29) aufweist.

## Revendications

1. Commutateur intelligent (100), notamment un fusible (101), comprenant au moins une entrée (103, 103', 103"), au moins une sortie (105, 105', 105", 105"') et un circuit de commutation (107) connectant électriquement la au moins une entrée (103, 103', 103") et la au moins une sortie (105, 105', 105", 105"'), dans lequel le circuit de commutation (107) comprend au moins deux sous-modules de commutation sélectionnés parmi la liste constituée d'un sous-module de commutation électromécanique (109) et d'un sous-module de commutation électrique (111), dans lequel le circuit de commutation (107) comprend au moins un sous-module de commutation électromécanique (109) et au moins un sous-module de commutation électrique (111), et dans lequel le commutateur comprend en outre une unité de commande (127) pour commander un état de fonctionnement des au moins deux sous-modules de commutation (109, 111) **caractérisé en ce que** l'unité de commande (127) est un microcontrôleur qui est connecté à la au moins une entrée (103, 103', 103") via une ligne d'alimentation en énergie (141).

2. Commutateur intelligent (100) selon la revendication 1, **caractérisé en ce qu'**au moins deux sous-modules de commutation sont connectés en série ou en parallèle dans le circuit de commutation (107).

3. Commutateur intelligent (100) selon la revendication 1 ou 2, **caractérisé en ce que** le sous-module de commutation électromécanique (109) est un sous-module de commutation monostable (113) ou un sous-module de commutation bistable (157).

4. Commutateur intelligent (100) selon l'une quelconque des revendications 1 à 3, **caractérisé en ce que** le sous-module de commutation électrique (111) est un commutateur à semi-conducteur (115), de préférence un transistor à effet de champ (FET) (117) ou un FET ingénieux.

5. Commutateur intelligent (100) selon l'une quelconque des revendications 1 à 4, **caractérisé en ce que** l'unité de commande (127) comprend au moins une interface de commande (137) pour connecter l'unité de commande (127) à un système de réseau situé à l'extérieur du commutateur intelligent (100).

6. Commutateur intelligent (100) selon l'une quelconque des revendications 1 à 5, **caractérisé en ce que** l'unité de commande (127) est connectée à chacun des sous-modules de commutation (109, 111) via une ligne d'entraînement (131, 133, 159, 161).

7. Commutateur intelligent (100) selon l'une quelconque des revendications 1 à 6, **caractérisé en ce que** le commutateur (100) comprend un sous-module de diagnostic (144).

8. Commutateur intelligent (100) selon la revendication 7, **caractérisé en ce que** le sous-module de diagnostic (144) comprend au moins un capteur (145) pour détecter au moins l'un parmi l'état de fonctionnement d'un sous-module de commutation, un courant de chemin, une température, et une tension.

9. Commutateur intelligent (100) selon la revendication 8, **caractérisé en ce que** le au moins un capteur (145) est connecté à l'unité de commande (127) via une ligne d'état (149, 149a).

10. Commutateur intelligent (100) selon l'une quelconque des revendications 1 à 9, **caractérisé par** un connecteur électrique automobile (1) comprenant un ensemble de base (11) ayant sur un côté de celui-ci une face de connecteur (7) avec la au moins une entrée (103, 103', 103") et la au moins une sortie (105, 105', 105", 105'") et ayant un côté intérieur (17) opposé à la face de connecteur (7), dans lequel le circuit de commutation (107) est agencé sur le côté intérieur (17).

11. Commutateur intelligent (100) selon la revendication 10, **caractérisé en ce que** la face de connecteur (7) comprend au moins trois bornes (9), de préférence la face de connecteur (7) comprend une prise ou une fiche ayant neuf bornes.

12. Commutateur intelligent (100) selon la revendication 10 ou 11, **caractérisé en ce que** l'unité de commande (127) comprend une interface de commande unique (137) qui est de préférence connectée ou correspond à l'une des bornes (9).

13. Commutateur intelligent (100) selon l'une quelconque des revendications 1 à 12, **caractérisé par** au moins une carte de circuit imprimé (21) comprenant au moins un composant électrique (27) ou électromécanique (29) sélectionné parmi le groupe constitué de sous-module de commutation électromécanique (109), sous-module de commutation électrique (111), unité de commande (127), ligne d'entraînement (131, 133, 159, 161), ligne d'alimentation en énergie (141), ligne d'état (149, 149a) et capteur (145).

14. Commutateur intelligent (100) selon la revendication 13, **caractérisé en ce qu'**au moins deux sections de carte de circuit imprimé (18) sont agencées sur le côté intérieur (17) qui s'étendent au loin de l'ensemble de base (11) et se font face l'une et l'autre, chaque section de carte de circuit imprimé (19) comprenant au moins un composant électrique (27) ou un composant électromécanique (29).
